# FASCICULE DE BREVET EUROPEEN

(11) **EP 2 052 289 B1**
(45) Date de publication et mention de la délivrance du brevet: **18.09.2019**
(21) Numéro de dépôt: 07823639.5
(22) Date de dépôt: 25.07.2007
(51) Int. Cl.: G02F 1/155, H05K 9/00

(54) **ELECTRODE TRANSPARENTE**
TRANSPARENTE ELEKTRODE
TRANSPARENT ELECTRODE

(30) Priorité: 16.08.2006 DE 102006038347; 27.09.2006 DE 102006045514
(43) Date de publication de la demande: 29.04.2009
(73) Titulaire: Sage Electrochromics, Inc., Faribault, MN 55021 (US)
(72) Inventeur: MELCHER, Martin, 52134 Herzogenrath (DE); LABROT, Michael, 52072 Aachen (DE); DUNKMANN, Benno, B-4000 Liege (BE); LETOCART, Philippe, B-4730 Raeren (BE); REUL, Bernhard, 52134 Herzogenrath (DE); OLLFISCH, Karl-Josef, 52159 Roetgen (DE); MAURER, Marc, F-60200 Compiegne (FR)
(74) Mandataire: Saint-Gobain Recherche
(86) Numéro de dépôt international: PCT/FR2007/051722
(87) Numéro de publication internationale: WO 2008/020141

(56) Documents cités:
- EP-A- 0 364 247
- WO-A-2006/040989
- WO-A1-99/40481
- FR-A- 2 821 937
- FR-A1- 2 791 147
- JP-A- 2000 114 770
- JP-A- 2004 363 467
- US-A- 3 947 837
- US-A- 4 772 760
- US-A1- 2002 130 605

## Description

L'invention concerne une électrode transparente avec les caractéristiques du préambule de la revendication de brevet 1.

On connaît d'après le document WO 99 / 40 481 A1 un système électrochromique qui comporte au moins une électrode transparente, laquelle électrode est conçue en tant que réseau de grille apériodique avec une conductivité élevée.

Les électrodes qui permettent une commutation très rapide des composants électrocommandables qu'elles alimentent font l'objet d'une forte demande. Les composants électrocommandables peuvent inclure, non seulement des éléments fonctionnels électrochromiques, comme cités ci-dessus par exemple, mais aussi des éléments fonctionnels électroluminescents, qui peuvent être commandés selon une grande surface ou par pixel. De tels éléments sont souvent utilisés pour l'affichage ou la représentation d'informations et d'images (afficheurs, écrans d'affichage et similaires).

D'autres utilisations connues de telles électrodes transparentes sont par exemple les systèmes de chauffage électriques et/ou des antennes et bien d'autres systèmes.

Pour la plupart de ces fonctions, une condition préalable est une très bonne conductivité électrique ou, autrement dit, une très faible résistance en surface de l'électrode transparente. Une autre condition est aussi requise de façon systématique lorsque l'électrode est intégrée dans un substrat verrier pour fenêtre transparente, que ce soit dans un bâtiment ou dans un véhicule, à savoir de minimiser l'impact optique à percevoir par l'oeil humain lequel est amené à cligner du fait du substrat.

On connaît également l'utilisation de telles électrodes transparentes pour absorber les rayonnements électromagnétiques ou protéger de ces derniers les utilisateurs d'un écran. Dans ce cas également, les électrodes doivent bien sûr réduire le plus possible toute gêne au passage des rayons de lumière. Par contre, concernant des buts de protection, le recours à des électrodes conductrices d'électricité de façon continue n'est pas une absolue nécessité (voir le document DE 10 2004 038 448 B3).

Dans le contexte particulier des pare-brise pouvant chauffer, deux structures de base existent à ce jour dans l'état de la technique. L'une de ces solutions utilise des couches conductrices transparentes et de surface homogène, lesquelles induisent cependant des coûts élevés pour permettre leur alimentation en énergie par le système électrique embarqué à cause de leur résistance de surface relativement importante (entre 2 et 4 ohms par unité de surface) (voir à ce sujet le document DE 10 2004 050 158 B3). De telles couches homogènes ne sont guère attrayantes sur un plan esthétique. L'autre solution concerne des fils très fins, le plus souvent des fils de tungstène, enrobés dans l'intercalaire de feuilletage en plastique des substrats feuilletées. Afin que l'impact optique créé par ces fils soit moins gênant, une pratique courante est appliquée depuis très longtemps, consistant à les enrober dans l'intercalaire de feuilletage avec des ondulations régulières ou pas (voir à ce sujet le document EP 443 691 B1).

Les deux systèmes sont en général reliés à la tension d'alimentation électrique à l'aide d'électrodes à ruban de basse impédance en bordure latérale.

Pour être exhaustif, il existe un troisième système, notamment des chauffages de substrat comportant des pistes conductrices imprimées (par sérigraphie) avec chauffage, qui du fait de leur impact optique ne trouvent une utilisation que dans les lunettes arrières. Les fils de tungstène évoqués plus haut ont une finesse encore beaucoup plus importante que les lignes déjà très fines pouvant être produites par des appareils de sérigraphie, même si des progrès importants ont été accomplis pour améliorer la largeur des pistes conductrices (DE 200 19 445 U1).

L'état de la technique tel que mentionné dans l'introduction, WO 99 / 40 481 A1, a déjà pour objectif de fournir une électrode efficace, dont l'impact optique créé est très réduit, avec un matériau conducteur à très basse impédance, et propose également dans une forme de réalisation de créer un réseau apériodique qui est décrit avec un modèle s'appuyant sur la physique. La grille peut être appliquée sur des substrats rigides ou souples (vitres, feuilles minces). Selon cet état de la technique, l'apériodicité de cette grille est principalement atteinte par déformation d'une grille régulière, en ce qu'en rapport avec le modèle, quatre ressorts de traction de raideurs différentes sont admis à chaque noeud dans des conditions aux limites déterminées au-dessus des écarts minimaux et maximaux entre deux noeuds voisins.

Avec ce motif, la formation d'effets de moiré sur deux structures de grille superposées en parallèle est empêchée et, comme il est affirmé, un impact optique créé plus faible que dans le cas de grilles périodiques en résulte. En même temps, il est indiqué que l'effet en surface de cette électrode est satisfaisant et est dépourvu de défauts d'homogénéité au moment de la commutation de la couche électrochromique.

L'état de la technique comprend notamment les documents EP0364247A, US2002/130605A1 et FR2791147A1 qui décrivent tous trois une électrode transparente sur un substrat support, comprenant un réseau de grille de lignes très fines conductrices électriquement, les lignes comportant des noeuds et des mailles, les lignes se rejoignant à chaque point étant courbées en forme d'arc ou dans une forme en ondulation.

Le but de l'invention est de fournir une autre électrode transparente avec une structure de grille conductrice, où une transparence élevée et donc un très faible degré de couverture en surface sont combinés avec un impact optique créé le plus minimal possible.

Ce but est atteint selon l'invention avec les caractéristiques de la revendication de brevet 1. Les caractéristiques des revendications dépendantes offrent des perfectionnements avantageux de l'invention.

L'électrode transparente selon l'invention est fabriquée à partir d'une grille en métal (de préférence en cuivre) sur un substrat approprié, que ce soit un substrat en verre ou en plastique ou une pellicule en plastique (PET), en utilisant un procédé de dépôt et d'enlèvement, de préférence, par lithographie optique. En fonction du type de structure de grille, la fabrication également à partir de fils individuels, pliés d'une façon conforme à la structure proposée est considérée.

La grille métallique représente donc une structure conductrice électriquement, qui convient pour un grand nombre d'utilisations différentes, mais surtout qui est particulièrement adaptée à l'intégration dans des substrats de fenêtre transparente.

A l'état final, elle peut être combinée par feuilletage selon une manière connue entre deux substrats rigide en verre ou en plastique, le cas échéant conjointement avec encore d'autres couches fonctionnelles à propos desquelles des détails seront donnés plus loin dans la description.

Les pistes de conduction de la grille ont une largeur d'environ 10 µm, par ailleurs elles ne peuvent pas être perçues par l'oeil humain à cause de la distance de lecture. Une couche de laque sombre est de préférence appliquée entre la feuille de substrat et les lignes conductrices métalliques de manière à améliorer encore l'effet produit optiquement ou de réduire davantage l'impact optique à percevoir.

La surface métallique résiduelle (éloignée du substrat) peut en plus être colorée pour la rendre plus noire ou dans une couleur plus foncée au moyen d'un traitement de surface.

En tant que caractéristique particulière, la réalisation de la grille selon l'invention utilise une structure de grille spéciale qui peut être déclinée selon plusieurs variantes, afin d'éviter des motifs de prisme ou de diffraction (qui peuvent être rendus optiquement sous forme « d'étoiles en couleur » ou de « phénomènes de papillotement » et qui sont incontournables dans le cas de motifs réguliers, en particulier quand ils comportent des contours maillés délimités par des angles droits et des lignes droites).

Une formule générale peut être imprimée de telle manière qu'une équipartition (statistique) des directions de l'ensemble des segments de ligne (0°à 180°) soit produite à l'intérieur de la structure de grille, laquelle équipartition, dans le cas idéal, provoque globalement un motif de diffraction en forme de cercle à chaque point souhaité de la structure de grille.

Par motif de diffraction, on entend ici l'effet résultant de ce que la lumière est diffractée aux « arêtes » de chaque ligne et que l'oeil humain reçoit une impression d'éblouissement déterminée ou, dans tous les cas, un impact optique est déterminé.

Selon un mode de réalisation non couvert par l'invention, on peut envisager des structures en désordre dans la mesure où seulement trois lignes se rejoignent à chaque noeud. Un avantage d'un tel motif basé sur un noeud à trois composantes réside en ce que les angles s'inscrivant respectivement entre deux sections conductrices aux noeuds sont plus grands, et dans tous les cas en moyenne plus grands dans un motif aléatoire. De ce fait, la production est simplifiée parce qu'il est possible de construire des coins avec une meilleure précision et que les crêtes électriques d'intensité de champ sont évitées.

Des structures régulières peuvent être envisagées avec la différence vis-à-vis de l'état de la technique que les lignes de liaison oscillent selon une forme en arc entre les noeuds, où elles peuvent de manière sélective comporter des courbes dans une direction uniquement ou aussi bien adopter un trajet dans une forme ondulée.

Dans ce dernier cas, des formes de réalisation préférées sont des mailles de grille combinées à partir de segments en quart de cercle. Ces dernières conviennent également pour la fabrication déjà mentionnée à partir de fils métalliques pliés distincts.

Afin d'améliorer la structure en couleur des cercles de diffraction dans la direction du blanc (et ainsi pour réduire encore l'impact optique créé par rapport à la lumière normalement reconnue comme en blanc), il est en plus possible de modifier l'intensité des conducteurs de façon aléatoire ou de façon systématique (par exemple entre 10 et 20 µm), tout en veillant dans tous les cas à préserver le masquage optique.

En particulier, dans le motif en désordre mentionné plus haut, les épaisseurs de fils peuvent être adaptées de telle sorte que la distribution du courant soit plus homogène et qu'en même temps le motif de diffraction soit atténué en couleur. Le procédé de fabrication par lithographie optique permet une reproduction fidèle des structures « aléatoires » une fois optimisées. L'optimisation proprement dite peut être effectuée par ordinateur à l'aide de programmes de simulation.

Pour l'utilisation dans des substrats de pare-brise à forte inclinaison, la grille est de préférence étendue dans la direction verticale de sorte que les distances de grille par rapport à la « direction d'observation » restent régulières dans la projection à la perpendiculaire.

Dans le « verre chauffant », donc dans les substrats pour fenêtre pouvant chauffer électriquement, l'électrode est utilisée, le cas échéant, sans fonction supplémentaire, simplement comme résistance chauffante. Lors de l'application d'une tension à deux connecteurs électriques ("busbars") appliqués sur des côtés opposés, la mise en température du substrat est lancée (dégivrage, désembuage). De telles applications peuvent bien sûr également être utilisées pour le chauffage des lucarnes et pour les cellules solaires afin de faire disparaître la neige.

Des avantages ou des possibilités particulières sont offertes dans le cadre de la réalisation selon l'invention en ce que
- dans une application de chauffage de substrat pour l'automobile, l'ouverture de maille de la structure de grille peut être définie de telle sorte que la puissance de chauffage souhaitée (environ 6 W/dm²) soit atteinte lors de l'application d'une tension embarquée de (12 à 14 volts continus). En l'occurrence, il serait possible d'appliquer les conducteurs électriques (« busbars ») soit sur les côtés étroits du substrat (ainsi une plus petite ouverture de maille de la grille peut être choisie de manière à rendre celle-ci encore moins visible), ou sur les côtés en longueur du substrat (ainsi une plus grande ouverture de maille de la grille peut être choisie, de manière à améliorer les valeurs de dispersion de la lumière et de sa transmission) ;
- la grille est transparente pour les rayonnements infrarouges et, pour cette raison, rien ne fait obstacle à une caméra embarquée ;
- par comparaison avec les chauffages par les fils, l'écartement réduit entre conducteurs (=> une répartition de la chaleur plus homogène) réduit de façon considérable l'effet de papillotement ;
- la répartition plus homogène de la chaleur rend également possible l'utilisation de substrats en plastique ;
- la grille peut être combinée avec une couche de contrôle solaire ou réfléchissant les rayonnements infrarouges, sans que la valeur plancher admise pour la transmission de la lumière ne soit dépassée ;

En particulier, dans le cas de la fabrication de la grille sur un substrat au moyen d'un procédé de lithographie optique ou un procédé similaire, il existe les possibilités supplémentaires permettant de :
- modifier l'ouverture de maille au-delà de la hauteur du substrat afin de pouvoir obtenir un chauffage homogène même dans le cas de surface en forme trapézoïdale ou de répartir la puissance de façon ciblée ;
- utiliser la grille métallique en tant qu'antenne du fait de discontinuités ciblées (fentes) ;
- augmenter la densité de la grille appliquée et/ou supprimer l'ouverture de maille de la grille appliquée dans les zones de bordure à proximité de l'encadrement d'une vitre de fenêtre et, au besoin, remplacer l'impression sérigraphique généralement noire en bordure, dans la mesure où des conditions aux limites telles que l'isolement électrique et des critères similaires sont pris en compte et sont satisfaits ;
- augmenter progressivement la densité de la grille vers le bord supérieur de sorte qu'elle puisse servir d'écran anti-éblouissant incorporé, désigné également comme « pare-soleil à bande » ;
- en accord avec le procédé, choisir la couleur de la laque entre la grille et le substrat ou de la pellicule PET indépendamment des autres surfaces, de sorte que l'impression de couleur depuis l'extérieur puisse être choisie indépendamment de la transparence vue depuis l'intérieur ;

Pour la fabrication de telles configurations, on emploie en tant que conducteurs électriques de préférence des conducteurs plats en cuivre étamés d'une manière connue en soi. Ceux-ci peuvent soit être directement déposés par soudage à l'aide d'un outil de soudage soit être simplement fixés (par des points de colle ou des rubans adhésifs, des agents adhésifs conducteurs, des points de soudure), puis être soudés d'une manière inductive après la stratification. Des méthodes de mise en contact d'un autre type, telles que le soudage par ultrasons ou le soudage inductif peuvent bien sûr également être utilisées. Concernant la brasure et d'autres méthodes de mises en contact, il existe des appariements de matière beaucoup plus avantageux que les fils en tungstène qui sont connus comme fournissant des résultats de soudure peu satisfaisants. De même, par rapport aux systèmes de couches minces connus, la grille obtenue par lithographie optique présente une meilleure résistance lors de la mise en contact et elle est donc moins fragile aux endommagements de la surface de contact. Dans la région des connexions des conducteurs électriques (« busbars »), il faut procéder à l'enlèvement d'une couche de surface en métal noircissante/ obscurcissante et non conductrice électriquement, sinon ces régions doivent être recouvertes avant le traitement de surface.

En principe, comme il a déjà été mentionné, une telle grille conductrice électriquement possède une fonction de protection contre des ondes (radio) électromagnétiques (haute fréquence) déterminées. Au cas où une transmission de telles ondes serait avérée nécessaire pour certains appareils électroniques, qui fonctionnent avec des ondes radio (GPS, paiement des péages, ...), on peut libérer une fenêtre de communication, en enlevant une découpe dans la pellicule PET déposée sur la grille. Afin d'éviter des inclusions d'air, une pellicule PET de même épaisseur sans grille peut être déposée dans le champ rendu libre.

Une autre variante consisterait à prévoir sur le substrat un champ libre (sans grille) dans l'agencement de la grille.

Ces deux moyens sont toutefois déjà connus dans la construction des pare-brise de voiture, qui sont pourvus d'un revêtement, conducteur électriquement, recouvrant la surface totale.

Pour la protection anti-corrosion, un bord d'environ 1 à 2 cm est laissé libre. Ceci est réalisé soit en retaillant l'ensemble de la pellicule PET + grille (lorsque la grille métallique va jusqu'au bord de la pellicule) ou en choisissant l'arrangement de la grille de manière à laisser un bord libre sur la pellicule PET, la pellicule PET elle-même s'étendant toutefois jusqu'au bord du verre, ou bien la grille s'étend jusqu'au bord de la pellicule PET, mais elle est interrompue le long d'une ligne circonférentielle (par exemple au moyen d'une application laser).

Lorsque la pellicule PET ne présente pas de découpe ni pour la protection anti-corrosion ni pour la fenêtre de communication, son épaisseur peut être choisie (par exemple, 125 µm au lieu de l'épaisseur habituelle de 50 µm), ce qui produirait des rayons de courbure accentués en bord de substrat.

Lorsqu'aucun élément spécifique à la substrat (fenêtre de communication, bord laissé libre) n'est prévu dans l'agencement de la grille, celle-ci peut être produite sous forme d'une bande sans fin. En particulier, quand elle est produite par lithographie optique, il n'est pas nécessaire de prévoir un photo masque pour chaque type de substrat. Les coûts sont donc réduits.

Lorsque l'agencement de grille ne prévoit aucun élément spécifique au substrat, la grille peut être produite soit feuille par feuille soit en tant que bande sans fin (rouleau) avec des formes alignées bout à bout.

La production industrielle en tant que bande sans fin (rouleau) est plus facile ; en particulier, elle simplifie la fabrication d'un préstratifié (PVB + PET/cuivre + PVB) dans un processus de fabrication à rouleaux continus, dans lequel le dépôt des conducteurs électriques doivent toutefois être réalisé de façon préalable. Une fois la pellicule ainsi fabriquée, elle peut alors être découpée.

Lorsque la grille métallique est utilisée pour la mise en contact de couches fonctionnelles (électrochromie, électroluminescence, lampes planes, diodes électroluminescentes organiques (OLED), antenne), au moins deux réalisations sont encore possibles:
- mise en contact capacitive: la grille métallique est appliquée sur le substrat verrier avec du PVB en tant que couche intermédiaire adhérente avec la couche fonctionnelle, de manière à éviter tout contact électrique (galvanique) direct.
- la couche fonctionnelle est appliquée sur la pellicule PET fonctionnelle de la grille métallique au lieu d'être appliquée sur le substrat verrier de manière à avoir un contact électrique direct.
- la couche fonctionnelle est séparée sur la grille appliquée sur le substrat en verre ou en plastique ; ainsi il y a ici aussi un contact électrique direct.

Par rapport aux couches transparentes, par exemple d'ITO (Indium Tin Oxide), l'avantage majeur de la structure de grille exposée ici réside en le niveau extrêmement faible d'impédance ohmique (de surface) (> 0,03 ohm/carré) pour une transmission de lumière meilleure (> 0,90 %).

Dans une application en tant qu'alimentation de courant transparente pour certains agrégats, la grille peut tout simplement remplacer une partie de câble ou servir à la mise en contact et de l'alimentation en courant des éléments électroniques intégrés dans le substrat (affichages, capteurs, corps lumineux ...).

Enfin, d'autres applications dans des systèmes d'alarme, par exemple pour l'identification de rupture (circuit fermé, signal lors d'une interruption) sont encore imaginables.

En plus, il est possible de combiner la structure de grille selon l'invention avec des dépôts en pleine surface « purs », qui peuvent par exemple servir à augmenter le contrôle solaire (réflexion infrarouge) du substrat de fenêtre dans son ensemble. Un tel revêtement peut être en contact direct avec la structure de grille, par exemple entre la structure de grille et le substrat ou être séparé du substrat par la structure de grille. Il peut également être disposé dans un tout autre plan d'un substrat feuilleté.

D'autres détails et avantages de l'objet de l'invention ressortiront du dessin des exemples de réalisation et de sa description détaillée ci-après.

On voit dans une représentation simplifiée, qui n'est pas à l'échelle, et selon une découpe sur :
la figure 1, une découpe provenant d'une première forme de réalisation d'une électrode transparente ou d'une structure de surface conductrice électriquement à partir d'une grille à lignes, dont les lignes sont réalisées en tant que quart de cercle de sorte que, en présence d'une régularité importante, une image de réfraction de la lumière puisse tout de même être définie dans la forme souhaitée;
la figure 2, une découpe provenant d'une seconde forme de réalisation exclue de l'invention avec une grille à lignes, dont les lignes s'étendant chaque fois entre deux noeuds sont réalisées comme des tiers de cercle ;
la figure 3, une découpe provenant d'une deuxième forme de réalisation exclue de l'invention avec une grille de lignes sans direction préférentielle ;
la figure 4, une coupe schématique effectuée à travers une électrode selon l'invention ;
les figures 5a et 5b, une juxtaposition de deux images de réfraction de sources de lumière ponctuelle - lumière transmise sur une grille rectangulaire régulière selon l'état de la technique et sur une grille configurée selon l'invention.

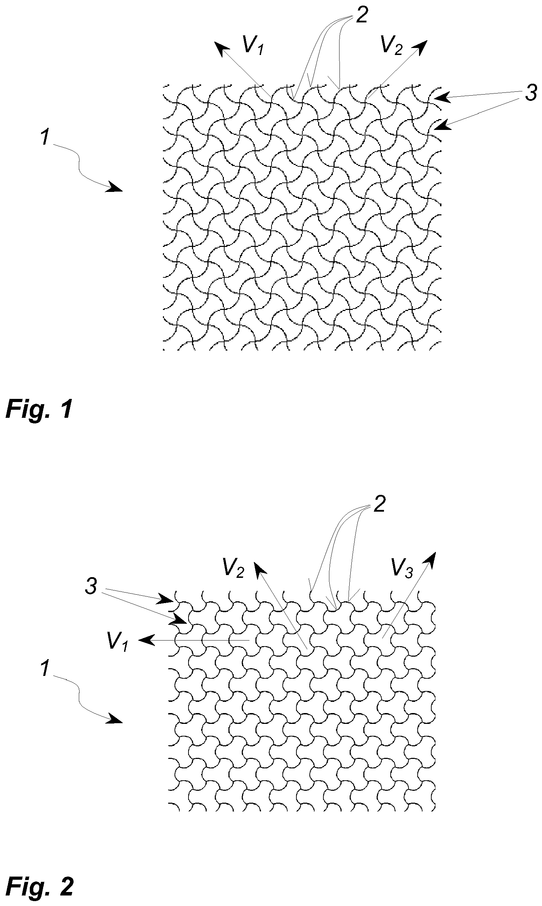

Conformément à la figure 1, une électrode transparente 1 est formée à partir d'une grille de lignes (en ondulation) fines 2 qui s'étendent le long de deux directions préférentielles avec un angle l'une par rapport à l'autre représentées par des flèches obliques tournées vers l'extérieur V₁, V₂. L'angle est ici un angle droit, ce n'est toutefois pas obligatoirement nécessaire.

Ces lignes, qui se croisent respectivement au noeud 3, sont appliquées sur un substrat transparent, tel qu'un substrat en verre ou en plastique ou une pellicule en plastique, au moyen d'un procédé approprié avec une épaisseur de ligne la plus réduite possible, par exemple par lithographie optique. Elles sont composées dans un matériau présentant une bonne qualité de conduction électrique, par exemple à base de cuivre métallique, d'argent ou d'autres matériaux. L'avantage particulier de cette réalisation réside en ce qu'une couche quasi continue est simulée par les mailles serrées de la grille avec une ouverture de maille de quelques dixièmes de millimètres, sans qu'il faille pour autant compter sur la résistance de surface relativement élevée des systèmes à couches minces connus. De même d'un point de vue purement mécanique, ces structures de grille sont plus résistantes que les systèmes à couches minces connus.

Dans la forme de réalisation montrée sur la figure 1, les lignes 2 sont réalisées en quarts de cercle avec une direction de courbure changeant constamment, où les points de croisement ou les noeuds 3 se situent exactement dans les changements de direction. Par cela, des mailles régulières apparaissent qui sont délimitées uniquement par les quarts d'arc.

La figure 2 montre une découpe provenant d'une autre forme de réalisation de l'électrode transparente 1 non couverte par l'invention. Ici, les lignes de grille 2 sont réalisées en tant que tiers de cercle entre chaque fois deux noeuds 3, où chaque maille est délimitée par respectivement trois lignes courbées vers l'extérieur par rapport au centre de la maille et respectivement trois lignes courbées vers l'intérieur par rapport au centre de la maille, qui se rejoignent contigüment de façon alternée. Sur cette base, il résulte la présence de trois directions préférentielles représentées par des flèches V₁, V₂ et V₃.

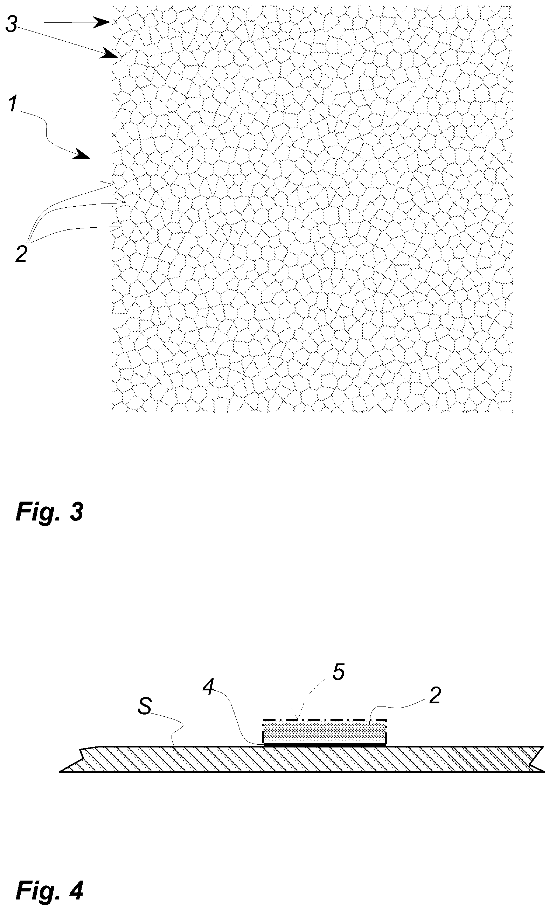

La figure 3 montre une autre forme de réalisation non couverte par l'invention sans direction préférentielle, où de nouveau une structure de maille avec une configuration en noeuds avec seulement trois lignes se rejoignant par noeud est, par contre, est produite. En l'occurrence, des sections conductrices distinctes peuvent toutefois être si justes qu'elles peuvent, sans grossissement, être perçues à l'oeil non protégé comme des noeuds à quatre composants. L'atteinte de l'effet de masquage souhaité dépend, bien que pas systématiquement, de ce que seulement trois lignes conductrices se rejoignent à tous les noeuds ; l'important est que ceci soit le cas pour une large proportion du nombre total de noeuds et qu'il ne résulte globalement aucune direction préférentielle.

Une telle structure de grille peut être produite en recourant à un nuage au moyen de l'algorithme suivant :
Les coordonnées des centres de mailles pour le nombre souhaité sont ensuite choisies de façon aléatoire. Les lignes de liaison sont déterminées à partir de chaque centre de maille vers les centres dans l'environnement. La perpendiculaire centrale est dessinée en relation avec chaque ligne de liaison, où les lignes en résultant sont coupées aux points de section avec les perpendiculaires centrales voisines.

La réalisation de cette prescription de construction peut toutefois aussi être décrite par une analogie relevant de la physique, que l'algorithme ci-dessus permet de réaliser :
La structure de grille correspond à la structure d'un nuage à deux dimensions qui résulte lorsque des bulles se forment à un point de démarrage pour un nombre de points aléatoires, lesquelles bulles se développent ensuite dans toutes les directions dans une forme égale, et ce jusqu'à ce qu'elles rencontrent des bulles voisines. La disposition des parois de séparation entre les bulles suit alors un motif aléatoire à partir de lignes droites sans direction préférentielle.

La figure 4, enfin, représente une coupe schématique avec un fort agrandissement, effectuée à travers un substrat S avec une ligne 2 de la structure de grille disposée dessus. On voit bien qu'une couche en couleur avec un contraste des couleurs 4 est disposée entre le substrat S et la ligne 2. Cette couche en couleur sert en particulier dans un environnement dans lequel on veut réduire de façon particulièrement importante l'impact optique gênant, en vue du masquage des lignes 2 et des points 3. Pour cette raison, elle se situe de préférence avant la structure de grille dans la direction d'observation, et ne présentera dans aucun cas des effets de miroitement.

Dans un substrat de pare-brise de véhicule, la couche en couleur 4 peut de façon facultative être plus proche pour la visibilité des occupants du véhicule et du conducteur que la structure de grille. Bien sûr, une telle couche en couleur sous-jacente n'empêche pas la mise en contact électrique de la structure de grille métallique.

Une autre couche en couleur 5 est indiquée en traits pointillés, laquelle couche sert également au masquage optique de la structure de grille Lorsque cette couche en couleur 5 n'est pas conductrice électriquement, elle doit bien sûr être enlevée au moins localement pour la mise en contact électrique de la structure de grille, par exemple dans la région des conducteurs électriques (« busbars ») mentionnées en préambule.

La différence optique entre les structures de grille correspondant à une réalisation classique (des rectangles réguliers) et les structures de grille selon l'invention est illustrée par les images de diffraction. Une image de diffraction est produite par la diffraction de la lumière qui est émise à travers une structure de grille, aux arêtes des sections de ligne des différentes mailles (comme aux arêtes d'une fente dans une surface qui sinon est opaque. Un effet de diffraction est créé au niveau de chaque fil (droit) individuel à la perpendiculaire de la direction du fil. Les motifs de diffraction de tous les fils sont ajoutés dans la lumière transmise.

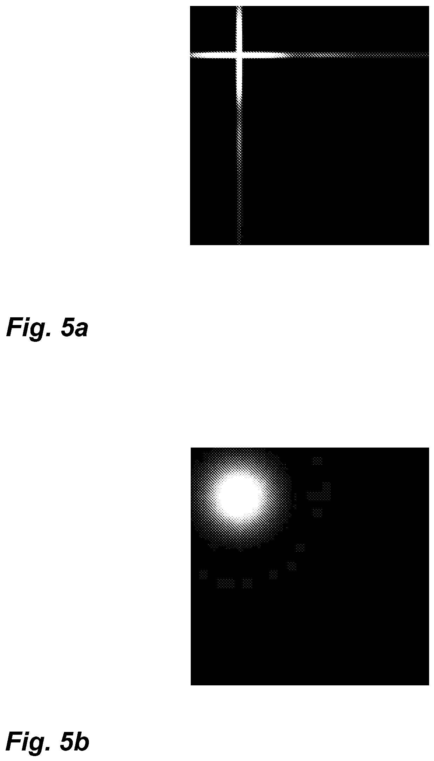

La figure 5a montre une image de diffraction d'une réalisation de grille avec des mailles régulières en rectangle ou en carré, tandis que la figure 5b montre une image de diffraction dans la réalisation de grille selon l'invention. Ces images de diffraction sont issues de simulations de l'observation directe d'une source lumineuse blanche à travers la grille, elles représentent cependant de façon exacte des prises de vue photographiques réelles du motif de diffraction de base. La différence entre les figures 5a et 5b est bien visible. Dans une grille en rectangle classique de la figure 5a, une image de diffraction est produite dans la forme d'une croix dont le marquage est net. Ceci s'explique en raison de la diffraction de la lumière sur les fils dans seulement deux directions contiguës précisément dans un angle droit, où chaque direction de fil se présentant crée, dans une vue en transparence, une ligne de diffraction (ou une barre traverse) qui lui est perpendiculaire.

En comparaison, la structure selon l'invention favorise la création d'une image de diffraction en forme de cercle (figure 5b), absorbée dans les structures de grille comme sur les figures 1 et 2.

Du fait que toutes les orientations de fil possibles peuvent apparaître dans une répartition régulière (motifs en arc de cercle) ou statistique (en nuage), la concentration des intensités de diffraction sur seulement deux barres et, par conséquent, les crêtes d'intensité associées sont évitées.

La forme d'arc de l'image de diffraction qui en résulte explique l'absence de ces crêtes d'intensité, ce par quoi les structures de grille selon l'invention sont moins visibles pour l'oeil humain dans la lumière transmise diffractée.

## Revendications

1. Électrode transparente sur un substrat support, rigide ou souple, comprenant un réseau de grille de lignes très fines conductrices électriquement (2) qui s'étendent selon deux directions préférentielles, les lignes comportant des noeuds (3) et des mailles, les lignes se rejoignant (2) à chaque point (3) étant courbées en forme d'arc avec une direction de courbure changeant constamment, où les noeuds se situent exactement dans les changements de direction, **caractérisée en ce que** ladite électrode est équipée d'au moins une connexion externe électrique, en particulier avec deux connexions externes opposées l'une à l'autre de part et d'autre de l'extension de surface de l'électrode, et **en ce que** les lignes sont réalisées en tant que quart de cercle.

2. Électrode selon l'une quelconque des revendications précédentes, **caractérisée en ce que** le réseau de grille est appliqué sur un substrat (S), lequel est doté d'au moins une couche adhésive pour un collage en surface avec un substrat rigide, en particulier avec un substrat de fenêtre.

3. Électrode selon l'une quelconque des revendications précédentes, **caractérisée en ce que** les lignes (2) du réseau grille ont une largeur entre 5 et 20 µm, où les lignes (2) d'un réseau grille sont réalisées soit toutes avec la même largeur soit avec de largeurs différentes de façon locale.

4. Électrode selon l'une quelconque des revendications précédentes, **caractérisée en ce qu'**une couche en couleur (4) destinée au masquage optique du réseau grille est disposée entre le substrat transparent (S) et les lignes (2) et points (3) du réseau de grille.

5. Électrode selon l'une quelconque des revendications précédentes, **caractérisée en ce qu'**une couche en couleur (5) en vue du masquage optique du réseau grille est disposée sur les surfaces à distance du substrat des lignes (2) et des points (3) du réseau de grille.

6. Électrode selon l'une quelconque des revendications 1 à 5, **caractérisée en ce que** le réseau de grille est fabriqué à partir de fils métalliques fins.

7. Électrode selon l'une quelconque des revendications précédentes, **caractérisée en ce qu'**au moins une partie de la surface de substrat est dépourvue de lignes (2) et de noeuds (3) du réseau de grille, en particulier une région de bordure et/ou une région prévue pour être traversée par des ondes électromagnétiques haute fréquence.

8. Électrode selon l'une quelconque des revendications précédentes, **caractérisée en ce qu'**un ruban de bordure du réseau grille est divisé au moyen d'une ligne de séparation à l'opposé de la région de surface centrale délimitée par lui.

9. Substrat transparent, qui est combiné par adhésion en surface avec une électrode selon l'une quelconque des revendications précédentes.

10. Substrat selon la revendication 9, **caractérisé en ce qu'**il est réalisé en tant que substrat feuilleté à partir de deux substrats en verre et/ou en plastique, entre lesquelles l'électrode est disposée en regard de leur substrat et est reliée avec ceux-ci par adhésion en surface par l'intermédiaire de couches de collage.

11. Utilisation d'une électrode selon l'une quelconque des revendications 1 à 8, dans laquelle l'électrode est combinée par adhésion en surface avec un substrat transparent et dans laquelle l'électrode est alimentée par une tension électrique par l'intermédiaire de connexions externes et de conducteurs électriques (« busbars ») pour chauffer ledit substrat.

12. Utilisation d'une électrode selon l'une quelconque des revendications 1 à 8, dans laquelle l'électrode est combinée par adhésion en surface avec un substrat transparent et dans laquelle l'électrode alimente en surface un composant électrique disposé sur le substrat.

13. Utilisation d'une électrode selon l'une quelconque des revendications 1 à 8, dans laquelle l'électrode est combinée par adhésion en surface avec un substrat transparent et dans laquelle l'électrode est réalisée en tant que capteur alimenté avec un courant de repos pour générer un signal en cas de bris du substrat, le substrat étant composé d'un substrat verrier sous tension.

## Patentansprüche

1. Transparente Elektrode auf einem starren oder flexiblen Trägersubstrat, umfassend ein Gitternetz aus sehr dünnen elektrisch leitenden Leitungen (2), die sich in zwei Vorzugsrichtungen erstrecken, wobei die Leitungen Knoten (3) und Maschen umfassen, wobei die Leitungen, die an jedem Punkt (3) miteinander verbunden sind (2), bogenförmig mit einer sich ständig ändernden Krümmungsrichtung gekrümmt sind, wobei sich die Knoten exakt in den Richtungsänderungen befinden, **dadurch gekennzeichnet, dass** die Elektrode mit mindestens einem externen elektrischen Anschluss ausgestattet ist, insbesondere mit zwei sich gegenüberliegenden externen Anschlüssen zu beiden Seiten der Oberflächenerstreckung der Elektrode, und dadurch, dass die Leitungen als Viertelkreis ausgebildet sind.

2. Elektrode nach einem der vorhergehenden Ansprüche, **dadurch gekennzeichnet, dass** das Gitternetz auf ein Substrat (S) aufgebracht ist, das mit mindestens einer Haftschicht zum flächigen Verkleben mit einem starren Substrat, insbesondere mit einem Fenstersubstrat, versehen ist.

3. Elektrode nach einem der vorhergehenden Ansprüche, **dadurch gekennzeichnet, dass** die Leitungen (2) des Gitternetzes eine Breite zwischen 5 und 20 µm aufweisen, wobei die Leitungen (2) eines Gitternetzes entweder alle gleich breit sind oder lokal unterschiedlich breit sind.

4. Elektrode nach einem der vorhergehenden Ansprüche, **dadurch gekennzeichnet, dass** zwischen dem transparenten Substrat (S) und den Leitungen (2) und Punkten (3) des Gitternetzes eine Farbschicht (4) zur optischen Maskierung des Gitternetzes angeordnet ist.

5. Elektrode nach einem der vorhergehenden Ansprüche, **dadurch gekennzeichnet, dass** auf den vom Substrat der Leitungen (2) und der Punkte (3) beabstandeten Flächen des Gitternetzes eine Farbschicht (5) zur optischen Maskierung des Gitternetzes angeordnet ist.

6. Elektrode nach einem der Ansprüche 1 bis 5, **dadurch gekennzeichnet, dass** das Gitternetz aus dünnen Metalldrähten hergestellt ist.

7. Elektrode nach einem der vorhergehenden Ansprüche, **dadurch gekennzeichnet, dass** zumindest ein Teil der Substratoberfläche frei von Leitungen (2) und von Knoten (3) des Gitternetzes ist, insbesondere eine Randregion und/oder oder eine Region, die von hochfrequenten elektromagnetischen Wellen durchquert werden soll.

8. Elektrode nach einem der vorhergehenden Ansprüche, **dadurch gekennzeichnet, dass** ein Randstreifen des Gitternetzes mittels einer Trennlinie gegenüber der von ihm begrenzten zentralen Oberflächenregion unterteilt ist.

9. Transparentes Substrat, das durch Oberflächenhaftung mit einer Elektrode nach einem der vorhergehenden Ansprüche kombiniert ist.

10. Substrat nach Anspruch 9, **dadurch gekennzeichnet, dass** es als laminiertes Substrat aus zwei Glas- und/oder Kunststoffsubstraten hergestellt ist, zwischen denen die Elektrode ihrem Substrat zugewandt angeordnet und mit diesen mittels Klebschichten durch Oberflächenhaftung verbunden ist.

11. Verwendung einer Elektrode nach einem der Ansprüche 1 bis 8, wobei die Elektrode durch Oberflächenhaftung mit einem transparenten Substrat kombiniert ist und wobei die Elektrode über externe Anschlüsse und elektrische Leiter ("Sammelschienen") mit einer elektrischen Spannung zum Erhitzen des Substrats versorgt wird.

12. Verwendung einer Elektrode nach einem der Ansprüche 1 bis 8, wobei die Elektrode durch Oberflächenhaftung mit einem transparenten Substrat kombiniert ist und wobei die Elektrode an der Oberfläche eine auf dem Substrat angeordnete elektrische Komponente versorgt.

13. Verwendung einer Elektrode nach einem der Ansprüche 1 bis 8, wobei die Elektrode durch Oberflächenhaftung mit einem transparenten Substrat kombiniert ist und wobei die Elektrode als Sensor hergestellt ist, der mit einem Ruhestrom versorgt wird, um im Fall von Substratbruch ein Signal zu erzeugen, wobei das Substrat aus einem Glassubstrat unter Spannung zusammengesetzt ist.

## Claims

1. A transparent electrode on a rigid or flexible support substrate, comprising a grid network of very fine electrically-conductive lines (2), which extend along two preferential directions, the lines comprising nodes (3) and links, the lines (2) joining up at each point (3) are bent in the shape of an arc with a constantly changing curvature direction, where the nodes (3) are located exactly in the changes of direction, **characterized in that** the electrode is equipped with at least one external electrical connection, in particular with two external connections opposite one another on both sides of the surface extension of the electrode, and **in that** the lines 2 are produced as quarters of circles.

2. The electrode as claimed in any one of the preceding claims, **characterized in that** the grid network is applied to a substrate (S), which is provided with at least one adhesive layer for surface-bonding with a rigid substrate, in particular with a window substrate.

3. The electrode as claimed in any one of the preceding claims, **characterized in that** the lines (2) of the grid network have a width between 5 and 20 µm, where the lines (2) of a grid network are produced either always the same width or with locally different widths.

4. Electrode according to any one of the preceding claims, **characterized in that** a colored layer (4) intended to optically mask the grid network is placed between the transparent substrate (S) and the lines (2) and points (3) of the grid network.

5. The electrode as claimed in any one of the preceding claims, **characterized in that** a colored layer (5), with a view to optically masking the grid network, is placed on the surfaces at a distance from the substrate, lines (2) and points (3) of the grid network.

6. The electrode as claimed in any one of claims 1 to 5, **characterized in that** the grid network is manufactured from thin metal wires.

7. The electrode as claimed in any one of the preceding claims, **characterized in that** at least one part of the substrate surface is free from lines (2) and nodes (3) of the grid network, in particular an border region and/or a region through which highfrequency electromagnetic waves are designed to pass.

8. The electrode as claimed in any one of the preceding claims, **characterized in that** an edging strip of the grid network is divided by means of a separation line on the opposite side of the central surface region delimited by it.

9. A transparent substrate, which is combined by surface bonding with an electrode as claimed in any one of the preceding claims.

10. The substrate according to Claim 9, **characterized in that** it is produced as a laminated substrate from two glass and/or plastic substrates, between which the electrode is positioned with respect to their substrate and is connected with these by surface bonding via bonding layers.

11. Use of an electrode as claimed in any one of the claims 1 to 8, in which in which the electrode is combined by surface-bonding with a transparent substrate, and in which the electrode is supplied with an electrical voltage via external connections and electrical conductors (busbars)to heat the substrate.

12. Use of an electrode as claimed in any one of the claims 1 to 8, in which the electrode is combined by surface-bonding with a transparent substrate, and in which the electrode is provided for the surface supply of an electrical component placed on the substrate.

13. Use of an electrode as claimed in any one of the claims 1 to 8, in which the electrode is combined by surface-bonding with a transparent substrate, and in which the electrode is produced as a sensor which may be supplied with a quiescent current to generate a signal in case the substrate breaks, where the substrate is composed of an energized glass substrate.
